# FASCICULE DE BREVET EUROPEEN

(11) **EP 3 432 031 B1**
(45) Date de publication et mention de la délivrance du brevet: **13.12.2023**
(21) Numéro de dépôt: 18183018.3
(22) Date de dépôt: 11.07.2018
(51) Int. Cl.: H01L 27/15, G01S 17/48, G01S 17/931, B60Q 1/00, H01L 25/16, F21S 41/153, F21Y 115/10

(54) **DÉTECTION D'OBJETS POUR UN VÉHICULE AUTOMOBILE**
OBJEKTERKENNUNG FÜR EIN KRAFTFAHRZEUG
OBJECT DETECTION FOR A MOTOR VEHICLE

(30) Priorité: 17.07.2017 FR 1756736
(43) Date de publication de la demande: 23.01.2019
(73) Titulaire: Valeo Vision, 93012 Bobigny Cedex (FR)
(72) Inventeur: THIN, Guillaume, 93012 BOBIGNY Cedex (FR); DE LAMBERTERIE, Antoine, 93012 BOBIGNY Cedex (FR); MBATA, Samira, 93012 BOBIGNY Cedex (FR); CANONNE, Thomas, 93012 BOBIGNY Cedex (FR); LESAFFRE, Olivier-Sébastien, 93012 BOBIGNY Cedex (FR)
(74) Mandataire: Valeo Visibility

(56) Documents cités:
- EP-A1- 1 553 429
- DE-A1-102005 041 466
- US-A1- 2008 046 150
- US-A1- 2008 119 993
- US-A1- 2009 225 330
- US-A1- 2012 050 694
- US-A1- 2014 098 556

## Description

### DOMAINE DE L'INVENTION

La présente invention concerne le domaine des systèmes et procédés de détection d'objets pour véhicule automobile.

### ARRIÈRE-PLAN

La perception de l'environnement qui entoure un véhicule automobile est primordial, notamment dans le contexte des voitures autonomes. Elle requiert la détection et l'évaluation de la distance des objets présents sur ou aux abords de la route.

La détection d'objets présents dans l'environnement d'un véhicule autonome est majoritairement assurée aujourd'hui par des lidars (acronyme anglais de *Light Détection and Ranging,* traduit en français par *Détection et mesure de distance par laser*) ou encore par des radars. Ces deux systèmes permettent de calculer la distance d'un objet se situant aux abords du véhicule. Ces systèmes envoient une onde, par exemple un faisceau laser ou encore un faisceau de micro-ondes, sur un objet qui le réfléchit : la distance de l'objet est alors déduite à partir du temps qui s'est écoulé entre le moment de l'émission de l'onde et le moment de la réception de l'onde réfléchie par l'objet.

Les radars et les lidars, bien que répandus dans le domaine des véhicules automobiles, présentent plusieurs inconvénients. Tout d'abord, ils nécessitent l'ajout de matériel embarqué qui encombre le véhicule. En général, ce matériel encombrant est placé sur le toit du véhicule, ce qui peut poser des problèmes d'aérodynamisme et accessoirement des problèmes d'esthétique. De plus, la précision des distances mesurées par un lidar est indépendante de la distance à laquelle se situe l'objet. En effet, les lidars fonctionnent par l'envoi d'un pic de lumière très court : la précision d'une distance mesurée par un lidar dépend de la durée de ce pic de lumière, quelle que soit la distance de l'objet. Une erreur ou une variation de quelques nanosecondes peut se traduire en une erreur d'évaluation de la distance de l'ordre du mètre, ce qui n'est pas acceptable dans le contexte de la sécurité automobile.

Dans ce contexte, il existe donc un besoin pour améliorer l'évaluation de la distance entre un véhicule automobile et un objet présent dans son environnement. Il est notamment important de développer une solution qui améliore la précision de l'estimation de la distance à mesure que l'objet se rapproche du véhicule, et qui ne requiert pas d'ajouter du matériel supplémentaire encombrant au véhicule.

Les documents DE 10 2005 041466 A1, US 2012/0050694 A1, EP 1 553 429 A1, US 2008/0046150 A1, US 2008/0119993 A1, US 2009/0225330 A1 et US 2014/0098556 A1 appartiennent à l'état de la technique antérieure considéré comme utile à la compréhension du contexte de la présente invention.

### RÉSUMÉ DE L'INVENTION

La présente invention propose pour cela un système de détection d'objet pour véhicule automobile selon la revendication 1 en annexe. Le système comprend une ou plusieurs matrices de sources lumineuses électroluminescentes, une ou plusieurs matrices de capteurs de lumière, une unité de calcul, et dans lequel système au moins une des sources lumineuses électroluminescentes est apte à émettre un signal, au moins un des capteurs est apte à recevoir le signal émis qui a été réfléchi par un objet, l'unité de calcul est apte à calculer par triangulation la position de l'objet en fonction de la position dans l'une des matrices de sources lumineuses électroluminescentes de ladite au moins une des sources lumineuses électroluminescentes apte à émettre un signal et de la position dans l'une des matrices de capteurs de lumière dudit au moins un des capteurs apte à recevoir le signal réfléchi par l'objet. En outre, dans le système selon la présente invention, lesdites une ou plusieurs matrices de sources lumineuses électroluminescentes sont des matrices monolithiques de diodes électroluminescentes, et lesdites une ou plusieurs matrices de capteurs de lumière sont des matrices monolithiques de diodes électroluminescentes utilisées comme capteurs de lumière. D'autres modes avantageux de réalisation de la présente invention sont l'objet des revendications dépendantes en annexe.

Le système selon la présente invention peut comprendre, en outre que:
- ladite au moins une des sources lumineuses électroluminescentes est apte à émettre le signal selon une direction contenue dans un cône d'émission, ledit au moins un des capteurs est apte à recevoir le signal réfléchi par l'objet selon une direction contenue dans un cône de réception, et l'unité de calcul est apte à calculer par triangulation la position de l'objet en outre en fonction d'un angle solide du cône d'émission et d'un angle solide du cône de réception ;
- une intersection du cône d'émission et du cône de réception définit un volume dans lequel se situe l'objet ayant réfléchi le signal émis ;
- ladite au moins une des sources lumineuses électroluminescentes est en outre apte à marquer le signal émis par codage du signal émis ;
- l'angle solide du cône d'émission est supérieur à l'angle solide du cône de réception ;
- au moins une desdites une ou plusieurs matrices de sources lumineuses est comprise dans un premier projecteur pour véhicule automobile.

Il est également proposé un procédé, selon la revendication 7 en annexe, de détection d'objet pour véhicule automobile qui comprend ou intègre le système selon l'invention. Le procédé comprend les étapes consistant à émettre, par au moins une des sources lumineuses électroluminescentes, un signal ; recevoir, par au moins un des capteurs, le signal émis qui a été réfléchi par un objet ; calculer, par l'unité de calcul, la position de l'objet en fonction de la position dans l'une des matrices de sources lumineuses de ladite au moins une des sources lumineuses électroluminescentes ayant émis le signal et de la position dans l'une des matrices de capteurs de lumière dudit au moins un des capteurs ayant reçu le signal réfléchi par l'objet.

Le procédé peut en outre comprendre :
- que le signal réfléchi par l'objet est reçu par plusieurs capteurs de lumière, et en outre, après l'étape de recevoir, l'étape consistant à déterminer le capteur ayant reçu la plus grande intensité du signal parmi lesdits plusieurs capteurs de lumière ayant reçu la lumière réfléchie par l'objet ; et que l'étape de calculer est réalisée avec la position dans l'une des matrices de capteurs de lumière d'un capteur qui a été identifié comme ayant reçu la plus grande intensité du signal réfléchi par l'objet ;
- former au moins deux ensembles de sources lumineuses électroluminescentes, un ensemble comprenant au moins un parmi : les sources lumineuses électroluminescentes d'une ou plusieurs lignes desdites une ou plusieurs matrices de sources lumineuses électroluminescentes ; les sources lumineuses électroluminescentes d'une ou plusieurs colonnes desdites une ou plusieurs matrices de sources lumineuses électroluminescentes ; au moins une des sources électroluminescentes qui est adjacente à au moins une des sources lumineuses électroluminescentes ayant précédemment émis le signal reçu ; sélectionner un des ensembles de sources lumineuses électroluminescentes ; et que l'étape d'émettre est réalisée par la ou les sources lumineuses électroluminescentes de l'ensemble sélectionné ;
- après une première itération du procédé, l'étape consistant à identifier ladite au moins une des sources lumineuses électroluminescentes ayant émis le signal reçu ; et que ledit un des ensembles de sources lumineuses électroluminescentes sélectionné comprend au moins une des sources électroluminescentes adjacentes à ladite au moins une des sources lumineuses électroluminescentes identifiée ;
- une période de répétition des étapes du procédé inférieure ou égale à 10 ms.

Il est également proposé, selon la revendication 12 en annexe, un programme d'ordinateur destiné à la détection d'objet pour véhicule automobile par le système selon l'invention, comportant des instructions de code de programme pour l'exécution des étapes du procédé selon l'invention lorsque ledit programme est exécuté sur une unité de traitement. L'unité de traitement peut être une unité de calcul du système.

Il est également proposé un support lisible ou accessible par une unité de traitement et sur lequel le programme d'ordinateur est stocké. Le support peut être une mémoire. La mémoire peut être intégrée au système selon l'invention.

De tels système et procédé de détection améliorent la détection d'un objet disposé sur un véhicule automobile. Ils s'inscrivent dans les technologies de projection d'un faisceau lumineux pixélisé. Un tel faisceau lumineux permet, grâce à son caractère pixélisé, de projeter un ou plusieurs signaux selon une direction bien déterminée. La précision de la détection est donc accrue par rapport aux systèmes et procédés connus. La précision ne repose pas sur les propriétés du signal envoyé, comme par exemple la durée d'un pic de lumière, mais sur les propriétés géométriques du système et un calcul par triangulation. En outre, le système selon l'invention peut s'intégrer facilement dans un véhicule automobile et sans encombrement supplémentaire. Notamment, les matrices de sources lumineuses électroluminescentes et de capteurs de lumière peuvent être intégrées dans les projecteurs d'un véhicule automobile de par leurs faibles dimensions. Et de plus une matrice de source lumineuse peut servir également de capteur, ce qui limite le nombre de composants utilisés dans le système de détection selon l'invention. En outre, le système de détection peut facilement être intégré avec des équipements déjà présents dans un véhicule : par exemple une caméra fournissant à un ordinateur de bord des informations sur l'environnement du véhicule peut être utilisée comme capteur du système de détection.

### BRÈVE DESCRIPTION DES FIGURES

Différents exemples de l'invention, nullement limitatifs, vont maintenant être décrits en se référant aux dessins annexés dans lesquels :
- FIG. 1 illustre un premier exemple de matrices de sources lumineuses pouvant être utilisées dans le cadre de l'invention ;
- FIG. 2 illustre un deuxième exemple de matrices de sources lumineuses pouvant être utilisées dans le cadre de l'invention ;
- FIG. 3 illustre un troisième exemple de matrices de sources lumineuses ne faisant toutefois pas partie de la présente invention telle que définie par les revendications en annexe
- FIG. 4 illustre un exemple de système de détection d'objets selon l'invention dans lequel un signal est émis par une des sources lumineuses électroluminescentes d'une matrice ;
- FIG. 5 illustre un exemple de système de détection d'objets selon l'invention dans lequel un signal est émis par deux sources lumineuses électroluminescentes d'une matrice ;
- FIG. 6 illustre un organigramme d'un premier exemple d'un procédé pour détecter un objet selon l'invention ;
- FIG. 7 illustre un organigramme d'un deuxième exemple d'un procédé pour détecter un objet selon l'invention ;
- FIG. 8 illustre un exemple de système de détection d'objets selon l'invention intégré dans un véhicule automobile ;
- FIG. 9 illustre le principe de triangulation dans un exemple de système de détection d'objets.

### DESCRIPTION DETAILLEE

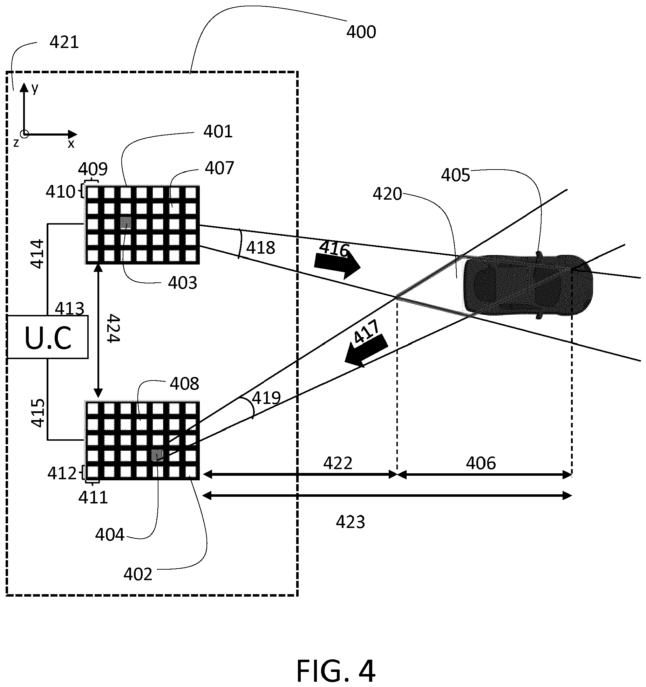

La FIG. 4 illustre un exemple de système de détection (400) d'objets (405) selon l'invention. Ce système de détection d'objets peut être compris dans un véhicule automobile. Par exemple, le système de détection selon l'invention peut être intégré entièrement ou en partie dans les dispositifs lumineux du véhicule, notamment dans les phares du véhicule. Des exemples d'intégration du système de détection d'objet selon l'invention sont décrits plus tard.

Un système de détection d'objets pour véhicule automobile 400 est un système permettant de découvrir automatiquement la présence d'un ou plusieurs objets dans l'environnement dans lequel évolue le véhicule. Automatiquement signifie que l'utilisateur n'intervient pas dans la détection. Le système de détection d'objets, lorsqu'il est intégré dans un véhicule, permet de préférence la détection d'objets situés sur la trajectoire du véhicule automobile, et plus généralement d'objets situés dans la scène du véhicule. La scène du véhicule peut être un espace entourant le véhicule, par exemple dans un rayon de 360° autour du véhicule. Une scène particulière est la « scène de route » qui est l'environnement du véhicule susceptible d'être éclairé par un projecteur du véhicule. Le système de détection intégré au véhicule permet de calculer la position de ces objets par rapport au véhicule automobile. Par conséquent le système permet d'évaluer la distance, la vitesse et la trajectoire des objets détectés par rapport au véhicule automobile.

Le système de détection 400 d'objet 405 comprend une ou plusieurs matrices 401 de sources lumineuses électroluminescentes 407. L'expression « matrice de sources lumineuses électroluminescentes » fait référence à un réseau de plusieurs sources lumineuses électroluminescentes qui sont disposées selon un motif qui peut être régulier. Ce motif, comme on peut le voir sur la FIG. 4, peut être une grille de sources lumineuses électroluminescentes ; la grille est formée de lignes 409 de sources lumineuses électroluminescentes et de colonnes 410 de sources lumineuses électroluminescentes. Dans ce contexte, les sources lumineuses électroluminescentes peuvent aussi être appelées pixels de la matrice ; on parle alors de grille de pixels.

Une matrice comprend plusieurs sources lumineuses électroluminescentes. Dans le cadre de la présente invention telle que revendiquée, chaque source lumineuse électroluminescente est une diode électroluminescente (acronyme français DEL, acronyme anglais LED). D'autres types de sources lumineuses électroluminescentes peuvent également être considérés, quoique ne faisant pas partie de la présente invention telle que revendiquée, par exemple: une diode électroluminescente organique (acronyme français DELo, acronyme anglais OLED) ou une diode électroluminescente polymérique (acronyme en français DELP, en anglais PLED). Plus généralement, une source lumineuse électroluminescente est un matériau qui émet de la lumière en réponse à un courant électrique qui le traverse, ou à un fort champ électrique.

Dans le cadre de la présente invention, lesdites une ou plusieurs matrices de sources lumineuses électroluminescentes sont des matrices monolithiques de DELs, alors appelées sources monolithiques : cela signifie que les éléments électroluminescents DELs sont situés sur un même substrat, et de préférence sur une même face du substrat qui peut être par exemple du saphir ou encore du silicium. Les sources lumineuses électroluminescentes DELs sont déposées sur ou s'étendent à partir d'au moins une face du substrat. Ces sources lumineuses électroluminescentes sont, dans le cadre de la présente invention telle que revendiquée, des DELs. Lorsque la matrice de sources lumineuses électroluminescentes est monolithique, comme dans le cadre de la présente invention, la matrice peut être à haute densité, c'est-à-dire qu'elle comprend un nombre très important d'éléments électroluminescents, au moins plusieurs centaines d'éléments électroluminescents. En pratique, la source comporte plus de 500 sources lumineuses électroluminescentes sur le même substrat. La densité de pixels est de préférence supérieure à 500 pixels par cm². Elle est typiquement comprise entre 500 et 2500 pixels par cm². On comprend que la densité de pixels d'une source lumineuse à haute densité de sources lumineuses électroluminescentes peut être supérieure à 2500 pixels par cm².

Chacune des sources lumineuses électroluminescentes de la matrice peut être électriquement indépendante des autres, c'est à dire émettre ou non de la lumière indépendamment de l'état (allumé, éteint, défectueux) des autres sources lumineuses électroluminescentes de la matrice. Dans ce cas, chaque source lumineuse électroluminescente de la matrice est commandée individuellement par un circuit électronique appelé « driver » en anglais ou microcontrôleur en français. Le driver gère l'alimentation électrique de la matrice qui est, dans le cadre de la présente invention, monolithique, ce qui revient à dire qu'il gère individuellement l'alimentation électrique de chaque source lumineuse électroluminescente DEL de la matrice. Alternativement, des sources lumineuses électroluminescentes peuvent être regroupées électriquement, par exemple en les alimentant électriquement à l'aide d'un montage en parallèle ou en série, afin de diminuer le nombre d'éléments à gérer. Les ensembles peuvent par exemple comprendre entre deux et quatre sources lumineuses électroluminescentes, ce nombre permettant de conserver un faisceau lumineux suffisamment pixélisé. Le driver est donc un dispositif électronique qui est apte à commander les éléments d'une matrice de sources lumineuses électroluminescentes. Plusieurs drivers peuvent être utilisés pour piloter les éléments de la matrice.

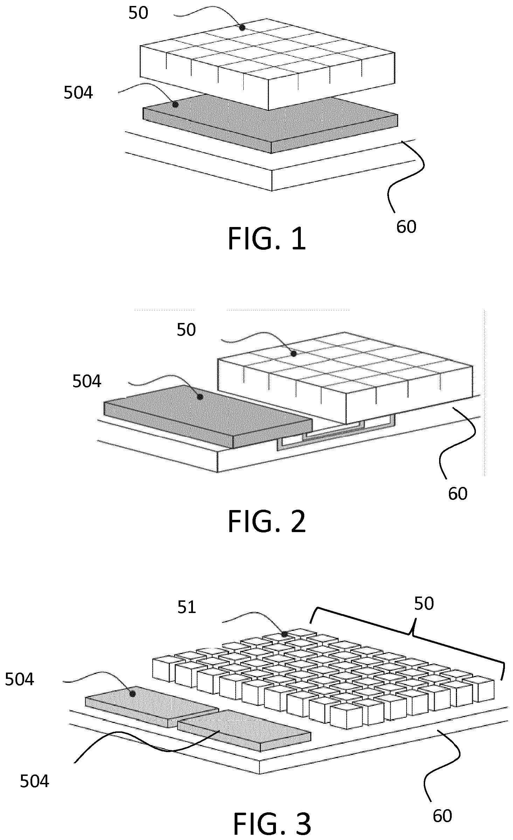

Des exemples de matrices de sources lumineuses électroluminescentes sont représentés sur les FIGs. 1 à 3.

La FIG. 1 illustre une matrice de sources lumineuses électroluminescentes 50, qui est dans cet exemple une source monolithique pouvant être utilisée dans le cadre de la présente invention. Un driver 504, qui permet de contrôler les sources lumineuses électroluminescentes DELs de la matrice de sources lumineuses électroluminescentes, est disposé entre matrice de sources lumineuses électroluminescentes 50 et un support 60.

La FIG. 2 illustre les mêmes éléments que ceux de la FIG.1, mais agencés différemment. Une matrice monolithique de sources lumineuses électroluminescentes 50 et un driver 504 sont disposés sur un support 60. Le driver 504 contrôle l'alimentation des éléments de la matrice. L'exemple de la FIG. 1 offre un meilleur gain de place que celui de la FIG. 2. L'exemple de la FIG. 2 permet néanmoins un meilleur refroidissement du driver 504 que l'exemple de la FIG. 1.

La FIG. 3 illustre un exemple semblable à celui de la FIG. 2, mais elle ne fait pas partie de la présente invention telle que revendiquée car la matrice de sources lumineuses électroluminescentes n'est pas monolithique. Les sources lumineuses électroluminescentes 51 de la matrice 50 sont disposées sur un support 60 et forment une grille comme évoqué en référence avec la FIG. 4. Dans cet exemple, deux drivers 504 contrôlent les sources lumineuses électroluminescentes 51 de la matrice 50. Il est également possible, dans un autre mode de réalisation, ne faisant pas non plus partie de la présente invention telle que revendiquée, que chacune des sources lumineuses électroluminescentes soit contrôlée par un driver.

Le système de détection comprend également une ou plusieurs matrices 402 de capteurs de lumière 408. L'expression « matrices de capteurs de lumière » fait référence à un réseau de plusieurs capteurs de lumière, qui sont disposés selon un motif qui peut être régulier. Un exemple de motif régulier est représenté sur la FIG. 4. Dans cet exemple le motif est une grille formée de lignes 412 de capteurs de lumière et de colonnes 411 de capteurs de lumière ; l'expression grille de capteurs peut également être utilisée.

Un capteur de lumière est un dispositif permettant de convertir un rayonnement électromagnétique en un signal électrique, pouvant être une variation de tension ou de courant électrique. Le rayonnement électromagnétique peut être de la lumière visible (par exemple la lumière blanche), ou de la lumière non-visible comme par exemple les UVs (Ultra-Violets) ou les IRs (Infra-rouges). Ces capteurs de lumière sont aussi appelés photodétecteurs.

Dans le cadre de la présente invention telle que revendiquée, des sources lumineuses électroluminescentes, en l'occurrence des diodes électroluminescentes, DELs, sont utilisées comme capteurs de lumière. Des photons émis par une source lumineuse monolithique à DELs sont captés au niveau d'une ou plusieurs autres DELs monolithiques d'une matrice monolithique de capteurs de lumières et les DELs qui captent les photons génèrent un courant électrique. Les propriétés physiques des diodes, c'est-à-dire leur jonction P-N, sont donc utilisées pour détecter de la lumière, et non plus (uniquement) pour émettre de la lumière. Ainsi, la matrice monolithique de capteurs de lumière est, selon la présente invention telle que revendiquée, une matrice monolithique de sources lumineuses électroluminescentes DELs comme illustré dans les exemples des FIGs. 1, 2, 4 et 5.

Les sources lumineuses électroluminescentes DELs d'une matrice de sources lumineuses électroluminescentes peuvent donc être utilisées comme capteurs de lumière. On peut envisager dans un exemple que les sources lumineuses électroluminescentes sont utilisées alternativement comme sources lumineuses et comme capteurs. Dans l'exemple de la FIG. 4, la matrice monolithique de sources lumineuses électroluminescentes 401 et la matrice monolithique de capteurs de lumière 402 sont espacées d'une distance 424. Cette distance 424 empêche ou limite les perturbations que pourrait créer le signal émis par une source lumineuse électroluminescente à DEL de la matrice 401 sur les capteurs DELs de la matrice 402.

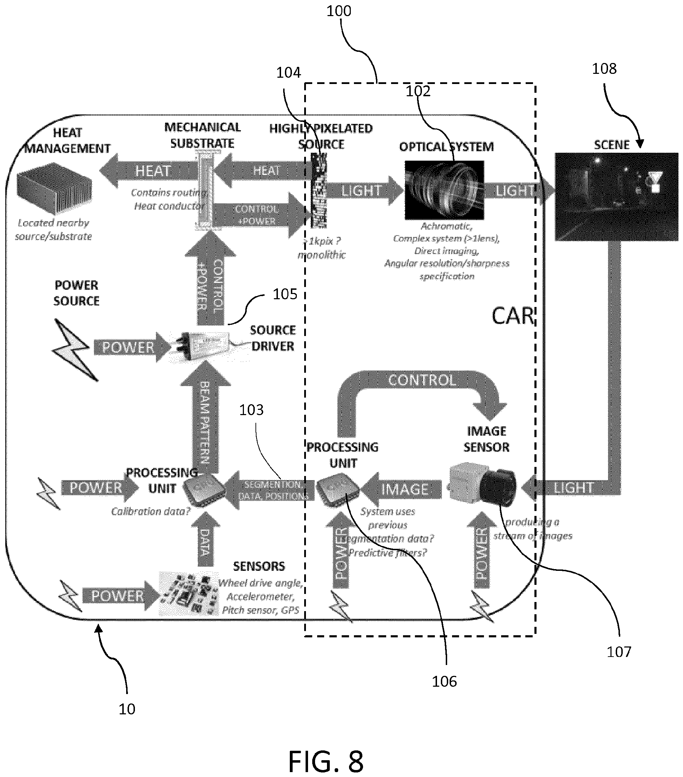

Dans un exemple, ne faisant toutefois pas partie de la présente invention telle que définie par les revendications, une caméra, qui comprend une ou plusieurs matrices de capteurs de lumière, habituellement des photodiodes, peut également être utilisée comme capteur. Un exemple de caméra est présenté dans la discussion de la FIG. 8.

Le système de détection d'objet comprend également une unité de calcul (UC) 413. L'unité de calcul permet de calculer la distance entre le système de détection d'objets et l'objet détecté. Lorsque le système de détection est intégré dans un véhicule, par exemple sur l'avant du véhicule, l'unité de calcul permet alors de calculer la distance entre l'objet détecté et le véhicule. L'unité de calcul peut être reliée à une mémoire afin d'y stocker les distances calculées. L'unité de calcul peut être par exemple une unité arithmétique et logique (UAL ou *ALU* - *Arithmetic logic unit* en anglais). L'unité de calcul peut recevoir des données de la matrice de sources lumineuses et de la matrice de capteurs de lumière, via par exemple les connexions 414 et 415. Ces connexions, par lesquelles transitent des bus de données, peuvent être filaires ou sans fil. L'utilisation de connexions filaires est préférée, car elle assure un transfert de données plus rapide et plus fiable.

Le système de détection intégré dans un véhicule permet de détecter un objet positionné dans l'environnement du véhicule et de déterminer la distance entre l'objet 405 et le véhicule. La distance est déterminée à l'aide du principe de triangulation. Comme illustré sur la FIG. 4, le signal émis, dont le sens de propagation est schématisé par la flèche 416, est réfléchi par l'objet 405 qui est dans cet exemple un autre véhicule se situant devant le véhicule intégrant le système 400 selon l'invention. Le signal réfléchi, dont le sens de propagation est schématisé par la flèche 417, est reçu par l'un des capteurs de la matrice de capteurs de lumière. Le calcul de la distance de l'objet est alors fait par triangulation en fonction de la position de la source lumineuse électroluminescente émettrice du signal dans la matrice de sources lumineuses électroluminescentes et de la position du capteur de lumière recevant le signal dans la matrice de capteurs de lumière. Ainsi, le calcul de la distance entre l'objet et le véhicule dépend de l'exécution des trois étapes suivantes.

Tout d'abord, un signal est émis par au moins une des sources lumineuses électroluminescentes de la matrice de sources lumineuses électroluminescentes. Typiquement ce signal est un signal lumineux.

Ensuite, le signal est réfléchi par un objet présent dans l'environnement du véhicule, par exemple le véhicule 405 de la FIG. 4. Les matrices de sources lumineuses et les matrices de capteurs de lumière sont de préférence disposées de manière à couvrir la scène de route ; par exemple, elles situent sur la face avant du véhicule intégrant le système 400.

Enfin, la distance est calculée suite à la réception du signal réfléchi par un des capteurs de lumière de la matrice de capteurs de lumière. Sans la détection du signal réfléchi, l'objet n'est pas détecté, et sa distance ne peut être évaluée. Il faut qu'au moins un des éléments de la matrice de capteurs puisse être apte à recevoir le signal réfléchi.

La propagation du signal émis par au moins un des éléments électroluminescents de la matrice de sources électroluminescentes est faite selon une direction qui est comprise dans un volume d'émission qui délimite la zone physique de l'environnement (et donc de la scène) dans lequel se propage le signal émis. Le volume d'émission est un cône d'émission, pouvant être par exemple un cône de révolution, ou un cône pyramidal si la source lumineuse électroluminescente a une forme en quadrilatère. La région de l'espace limitée par le cône d'émission, non nécessairement circulaire, est un angle solide identifié 418 sur la FIG. 4. Les sources lumineuses électroluminescentes DELs de la matrice monolithique de sources lumineuses électroluminescentes sont généralement identiques : dans ce cas, et selon la présente invention, ces sources lumineuses électroluminescentes présentent des cônes d'émission avec des propriétés géométriques similaires, c'est-à-dire des angles solides identiques. En tout état de cause, chaque source lumineuse électroluminescente peut être définie comme étant une source ponctuelle à laquelle est associée un volume d'émission dans lequel rayonne la source lumineuse électroluminescente ; l'ensemble de ces volumes d'émission définissant le volume de l'espace de la scène éclairé par la matrice.

Un signal réfléchi par un objet est reçu par au moins un capteur de lumière de la matrice monolithique de capteurs à base de DELs de lumière. Le signal réfléchi reçu est caractérisé par le fait qu'il s'est propagé dans un volume de réception (on peut aussi dire qu'il se propage à l'intérieur d'un volume de réception). Tout comme un volume d'émission, un volume de réception est un cône de réception pouvant être par exemple un cône de révolution ou un cône pyramidal. La région de l'espace limitée par le cône de réception, non nécessairement circulaire, est un angle solide identifié 419 sur la FIG. 4. Le cône de réception délimite l'espace physique de l'environnement dans lequel se propage le ou les signaux réfléchis pouvant être reçus par le capteur de lumière associé au cône de réception. Ainsi, seuls les signaux se propageant dans un cône de réception sont détectés par le capteur de lumière associé à ce cône de réception. En tout état de cause, chaque capteur de lumière peut être défini comme étant un capteur de lumière auquel est associé un volume de réception dans lequel se propage le signal pouvant être reçu par ce capteur de lumière ; l'ensemble de ces volumes de réception définissant le volume de l'espace où doivent se propager les signaux réfléchis pour être reçus par au moins un des capteurs de lumière de la matrice.

La réception d'un signal réfléchi par au moins un des capteurs de lumière de la matrice de capteurs de lumière traduit la détection d'un objet 405. Le système de détection d'objets détermine alors la position de l'objet détecté par rapport au véhicule. Déterminer la position de l'objet par rapport au véhicule 400 dans lequel est intégré le système de détection d'objets signifie donner la position de l'objet dans le référentiel 421 lié au système de détection d'objets et au véhicule.

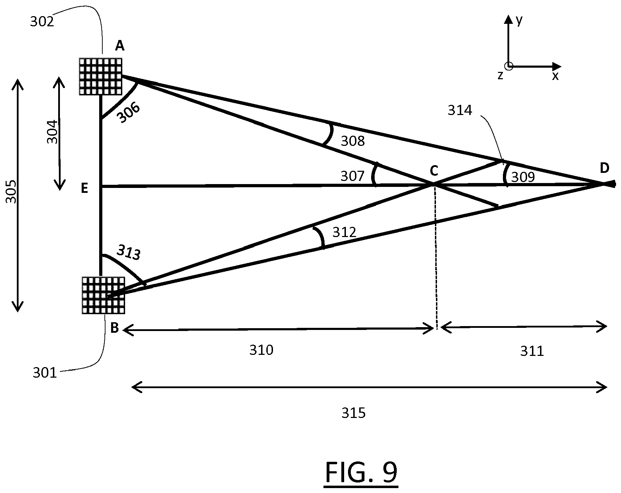

Tout ou partie de l'objet détecté se trouve dans le volume défini par l'intersection du cône d'émission avec le cône de réception : ce volume se matérialise en deux dimensions sur la FIG. 4, par un quadrilatère 420. Ce volume définit la zone probable où se trouve l'objet, ou tout du moins une partie de l'objet (ici l'arrière du véhicule 405). Il existe une certaine probabilité que l'objet se situe dans le volume. Le volume défini par l'intersection des deux cônes comprend une longueur maximale 406, soit la plus grande distance entre deux points appartenant au volume. La probabilité de présence de l'objet varie au sein de cette zone. La distance 422 correspond à la distance minimale à laquelle il est probable que l'objet se trouve et la distance 423 correspond à la distance maximale à laquelle il est probable que l'objet se trouve. Ces deux distances, 422 et 423, sont déterminées par triangulation dont le principe est expliqué en référence à la FIG. 9.

Les cônes de réception et les cônes d'émission peuvent avoir des angles solides de dimensions différentes. Dans un premier exemple, toutes les sources lumineuses électroluminescentes d'une matrice ont des cônes d'émission ayant une première valeur d'angle solide qui est identique pour toutes les sources de la matrice, et tous les capteurs d'une matrice de capteurs de lumière ont des cônes de réception ayant une deuxième valeur d'angle solide qui est identique pour tous les capteurs. La première valeur peut être supérieure à la deuxième valeur, ou inversement, la deuxième valeur peut être inférieur à la première valeur. La réduction ou l'augmentation de ces premières ou deuxièmes valeurs d'angle solide peut être obtenue par exemple à l'aide de dispositif optiques connus.

L'émission d'un signal par au moins une des sources lumineuses électroluminescentes de la matrice de sources lumineuses électroluminescentes peut être pilotée par un driver. Le signal émis peut être un signal lumineux. Ce signal lumineux se propage de manière sensiblement rectiligne selon une direction qui est comprise dans le cône d'émission de la source électroluminescente émettrice de ce signal.

Le signal lumineux envoyé peut être marqué par la source lumineuse électroluminescente qui l'émet. Par exemple, le marquage peut consister en un codage du signal lumineux émis. Le codage peut être réalisé par une modulation du signal lumineux émis. La modulation de signal lumineux traduit un processus par lequel une (ou une combinaison de deux ou plus) des grandeurs caractéristiques du signal lumineux, choisie(s) parmi l'amplitude, la phase ou la fréquence, est modifiée.

Le marquage du signal émis, c'est-à-dire son codage, permet de transmettre au récepteur l'information que le signal réfléchi par l'objet est un signal qui a été émis par l'une des sources lumineuses électroluminescentes du système de détection, et non pas une source lumineuse de la scène telle que par exemple celle d'un autre véhicule ou encore un lampadaire. En outre, le marquage peut permettre de distinguer un signal parmi une pluralité de signaux envoyés par une ou plusieurs matrices de sources lumineuses. Pour chaque signal détecté, il est donc possible d'identifier la source lumineuse électroluminescente qui l'a émis. Le marquage joue donc le rôle d'un identifiant unique de chaque signal envoyé, ce qui permet de construire pour chaque signal détecté un couple qui comprend la source lumineuse électroluminescente ayant émis le signal et le capteur de lumière ayant reçu le signal.

L'envoi d'un signal peut être réalisé par un ou plusieurs pixels 407 de la matrice 401. Lorsque l'émission du signal est faite par plusieurs pixels, l'émission du signal est de préférence réalisée simultanément par l'ensemble des diodes électroluminescentes 407 envoyant le signal afin d'accroître la précision du système de détection et d'éviter que des erreurs puissent se produire lors de la détermination de la position de l'objet. Emettre simultanément signifie que les deux ou plus sources électroluminescentes émettent de la lumière à un même moment dans le temps, ce même moment pouvant comprendre un intervalle de temps.

La détermination de la position de l'objet par rapport au véhicule peut comprendre la détermination des distances 422 et 423 indiquées sur la FIG. 4. Pour cela, on utilise le principe de triangulation qui est illustré à la FIG. 9. La FIG. 9 est une représentation en deux dimensions (2D) - dans le plan (x,y) du référentiel 421 de la FIG. 4- dans laquelle les distances 422 et 423 susmentionnées sont notées 310 et 311. Les angles solides caractérisant les cônes d'émission et de réception, sont respectivement représentés par les angles 308 et 312. De manière similaire, le volume de présence probable de l'objet se matérialise en deux dimensions par un quadrilatère 314, qui est la zone où la présence de l'objet est probable. La triangulation consiste à déterminer la position d'un sommet d'un triangle connaissant la distance séparant les deux autres sommets et les angles de la base du triangle en utilisant les formules de trigonométrie connues. Par exemple, peuvent être connus le triangle ABC de la FIG. 9 : la distance 305 séparant la source lumineuse de la matrice 302 ayant émis le signal et le capteur de la matrice de capteurs de lumière 301 ayant reçu le signal, les angles 306 et 313 de la base du triangle. Ces données, permettent ainsi de déterminer, par triangulation la distance 310 indiquée sur la FIG. 9. Dans un autre exemple s'appliquant cette fois-ci au triangle ABD : connaissant les angles 306 et 313 de la base du triangle, les angles solides 308 et 312 des cônes d'émission et de réception, et la distance entre la source lumineuse de la matrice 302 ayant émis le signal et le capteur de la matrice de capteurs de lumière 301 ayant reçu le signal, il est possible de calculer la distance 315. La triangulation permet de déterminer les trois grandeurs caractérisant la position de l'objet détecté : la distance minimale à laquelle il est probable que l'objet se trouve 310, la distance maximale à laquelle il est probable que l'objet se trouve 315 et la distance 311 qui représente la différence entre les deux. Cette distance 311 est la « longueur » de la zone 314 où la présence de l'objet est probable. Par longueur de la zone probable de présence de l'objet on comprend la différence entre la position probable minimum 310 et la position probable maximum 315 de l'objet par rapport au véhicule.

La détermination de ces grandeurs dépend des positions de la source lumineuse électroluminescente émettrice et du capteur de lumière récepteur respectivement dans la matrice de sources lumineuses électroluminescentes et la matrice de capteurs de lumière. En effet, les angles de la base des triangles ABC et ABD dépendent de ces positions. En d'autres termes, le calcul de la position d'un objet est réalisé à l'aide de la position dans sa matrice de la source lumineuse électroluminescente ayant émis le signal et de la position dans sa matrice de capteurs du capteur de lumière ayant reçu le signal réfléchi par l'objet.

Comme évoqué précédemment, il est possible que les angles solides du cône d'émission et du cône de réception soient identiques ou qu'ils aient des valeurs différentes. En référence à la FIG. 9, on comprend que plus les angles solides des cônes d'émission et de réception sont grand, plus la zone où la présence de l'objet est probable est grande. L'augmentation de la distance séparant la ou les matrices de sources lumineuses de la ou les matrices de capteurs peut également permettre de réduire la longueur de la zone de présence probable de l'objet, et donc d'améliorer la précision du calcul de la distance de l'objet. Par exemple, une application numérique dans le cas où la résolution de la matrice de sources lumineuses électroluminescentes est de 0.1° et que l'objet est positionné à 20 m, la longueur de la zone de présence probable de l'objet est 1,24 m pour une distance de 1,2 m et est de 0,73 m pour une distance de 2 m entre la matrice de sources lumineuses électroluminescentes et la matrice de capteurs de lumière.

La longueur de la zone 311 dans laquelle il est probable que l'objet est situé peut également varier en fonction de la distance de l'objet à détecter par rapport au système de détection. Plus l'objet à détecter est proche, plus la zone de présence probable de l'objet, et donc sa longueur, est réduite. Par exemple, une application numérique dans le cas où la résolution de la matrice de sources lumineuses électroluminescentes est de 0,1° et qu'une distance de 1,2 m sépare la matrice de sources lumineuses électroluminescentes 302 et la matrice de capteurs 301, la détection d'un objet à 20 m se fait avec une précision de 1,24 m et la détection d'un objet à 10 m se fait avec une précision de 0,3 m.

La FIG. 8 illustre un exemple d'intégration d'un système de détection d'objets 100 selon l'invention dans un véhicule automobile, plus particulièrement dans le dispositif lumineux 10 du véhicule. Le terme véhicule automobile couvre tout type de véhicule terrestre, par exemple une automobile voiture, une motocyclette, ou un camion. Le dispositif lumineux 10 peut être compris dans un véhicule terrestre afin d'éclairer une scène 32, par exemple une route. Le dispositif lumineux 10 comprend au moins un projecteur qui comprend une matrice de sources lumineuses 104 et un système optique 102 permettant la formation d'un faisceau lumineux. Le projecteur peut être un projecteur implémentant des fonctions telles que par exemple une fonction « feu de route » et/ou « feu de croisement ». La matrice de sources lumineuses est dans l'exemple de la FIG. 8 une source pixélisée monolithique 104 de sources lumineuses électroluminescentes à DELs.

La source pixélisée monolithique émet de la lumière, sous commande d'un driver 105, qui est transformée en un faisceau lumineux à l'aide d'un système optique 102. Ce faisceau lumineux est projeté sur une scène 108, ou « scène de route » qui est l'environnement du véhicule susceptible d'être éclairé par le dispositif lumineux du véhicule. Au moins une des sources lumineuses électroluminescentes de la matrice 104 est apte à envoyer un signal lumineux, codé par exemple par modulation du signal. Un objet présent dans la scène éclairée peut réfléchir le signal envoyé par ledit au moins un élément électroluminescent, et le signal réfléchi peut-être détecté par un des capteurs de la matrice de capteurs de lumière du système de détection.

Toujours dans cet exemple, une caméra 107 peut être utilisée pour détecter la réflexion du signal émis. Une caméra est un dispositif particulier adapté pour la détection d'un signal lumineux. Une caméra peut comprendre une ou plusieurs matrices de capteurs de lumière. La ou les matrices de capteurs d'une caméra peuvent être des matrices de diodes photosensibles. À noter que, dans le cadre de la présente invention telle que définie par les revendications, l'une ou plusieurs matrices de capteurs sont des matrices monolithiques de DELs utilisées comme capteurs de umière.

La détection du signal par la caméra 107, permet le calcul 103 par triangulation de la distance de l'objet par rapport au véhicule. Ce calcul peut être réalisé par un processeur 106 qui joue donc le rôle d'unité de calcul. Dans cet exemple, la résolution de la caméra 107, c'est-à-dire la résolution de la matrice de capteurs de lumière, est supérieure à la résolution de la matrice de sources lumineuses électroluminescentes. Ainsi, l'angle solide du cône d'émission est supérieur à l'angle solide du cône de réception ; l'utilisation d'une caméra qui a une résolution plus importante qu'une matrice de sources lumineuses électroluminescentes, permet notamment de réduire l'erreur 311 de la distance 310 calculée - et présumée - de l'objet. La caméra peut être intégrée dans le dispositif lumineux, c'est-à-dire dans le phare du véhicule. Elle peut alternativement être intégré dans le véhicule ; par exemple la caméra peut être la même que celle habituellement utilisée pour exécuter une fonction de type anti-éblouissement.

Selon la présente invention telle que revendiquée, la ou les matrices de capteurs de lumière sont des matrices monolithiques de diodes électroluminescentes utilisées comme capteurs de lumière. En effet, les sources lumineuses électroluminescentes monolithiques DELs sont, dans le cadre de la présente invention, utilisées comme capteurs de lumière. Dans des exemples, les sources lumineuses lectroluminescentes à DELs fonctionnant comme capteurs sont alors disposées dans un projecteur distinct du projecteur où est disposée la matrice de sources lumineuses électroluminescentes à DELs émettrice du signal.

En pratique, on privilégie l'utilisation d'une caméra, celle-ci pouvant être disposée dans le même projecteur que la matrice de sources lumineuses électroluminescentes à l'origine de l'envoi du signal ou dans un projecteur distinct.

Le système de détection selon l'invention peut être disposé indifféremment à l'avant comme à l'arrière du véhicule et indifféremment à la gauche ou à la droite de ce dernier. Il est en outre possible que le système comprenne deux matrices de sources lumineuses électroluminescentes qui sont utilisés alternativement comme matrice de sources lumineuses électroluminescentes et comme matrice de capteurs de lumière.

Le système de détection selon l'invention peut ainsi être indifféremment intégré dans un projecteur avant gauche et/ou avant droit et ou arrière gauche et/ou arrière droit. Dans un premier exemple dans lequel le système de détection est intégré dans les deux projecteurs avant d'un véhicule, chaque projecteur peut être soit un émetteur, soit un récepteur, ou encore être alternativement un émetteur et un récepteur. Plusieurs configurations d'intégration dans un véhicule automobile sont envisageables. Dans une première configuration, le projecteur droit comprend une matrice de sources lumineuses électroluminescentes servant de récepteur, et le gauche une matrice de sources lumineuses électroluminescentes servant d'émetteur; ou inversement. Dans une deuxième configuration, le projecteur droit comprend une matrice de sources lumineuses électroluminescentes servant d'émetteur, et le projecteur gauche une caméra servant de détecteur; ou inversement. Dans cette deuxième configuration, le projecteur gauche peut également comprendre une matrice de source lumineuse électroluminescente (ou tout autre type de source de lumière) servant à éclairer la scène, le projecteur droit pouvant utiliser une matrice de sources lumineuses électroluminescentes pour à la fois éclairer la scène et envoyer des signaux ; ou inversement.

Le système de détection selon l'invention peut être intégré dans un véhicule automobile à deux roues, par exemple une motocyclette qui ne comprend qu'un projecteur. Dans cet exemple, le projecteur comprend au moins une matrice de sources lumineuses électroluminescents et une matrice de capteurs.

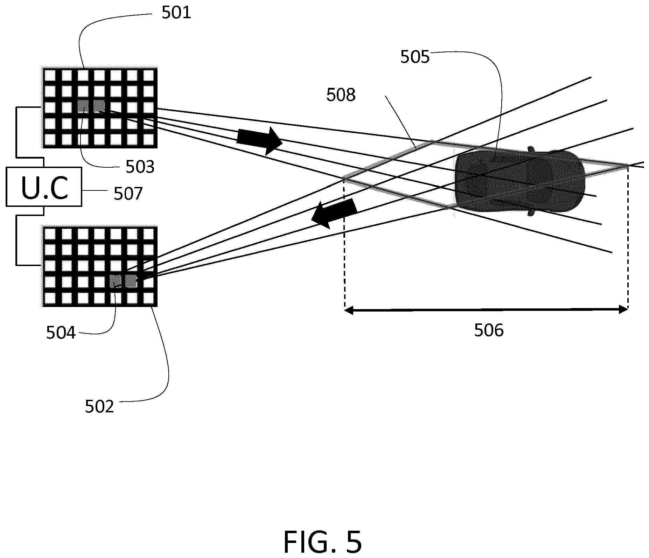

La FIG. 5 illustre un autre exemple de système de détection d'objets selon l'invention. Tout comme dans la FIG. 4, le système comporte une matrice monolithique de sources lumineuses électroluminescentes DELs 501, une matrice monolithique de capteurs de lumière à DELs 502, et une unité de calcul 507 sur laquelle les deux matrices sont connectées. Un objet 505 (un véhicule dans cet exemple) est situé en face du système de détection. Dans cet exemple, le signal est simultanément envoyé par deux éléments électroluminescents 503. Les deux signaux envoyés sont réfléchis par l'objet 505, et les signaux réfléchis sont détectés par deux capteurs 504 de la matrice de capteurs de lumière. L'intersection des cônes d'émission et des cônes de réception respectivement des éléments électroluminescents émetteurs et des capteurs définit un volume - représenté en deux dimensions sur la FIG. 5 par un quadrilatère 508 -, où la présence de l'objet est probable. La « longueur » de la zone, distance entre le point du quadrilatère le plus proche du véhicule et le point du quadrilatère le plus éloigné du véhicule, est indiquée par la double flèche 506. Dans cet exemple de la FIG. 5, chaque source lumineuse envoie un signal qui est codé de sorte que chaque signal parmi ceux envoyés simultanément sont individuellement identifiables. Il est donc possible de construire pour chaque signal détecté un couple source lumineuse électroluminescente DEL ayant émis le signal / capteur de lumière à DEL Z ayant reçu le signal.

L'exemple de la FIG. 5 a été présenté pour deux sources lumineuses électroluminescentes voisines -c'est-à-dire qu'elles ont au moins un bord commun- qui envoient simultanément un signal lumineux. Dans d'autres exemples, plus de deux sources électroluminescentes peuvent envoyer un signal, et lesdites plus de deux sources électroluminescentes peuvent être voisines ou non.

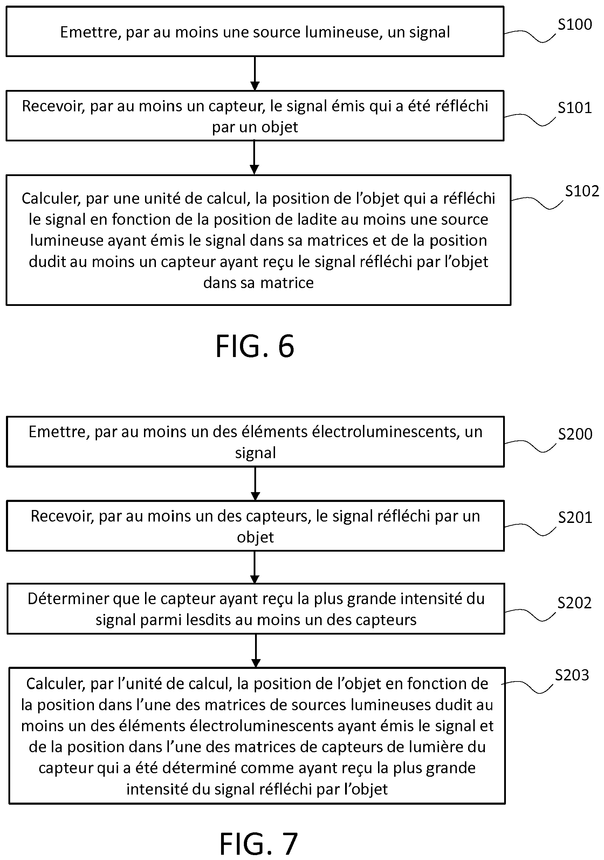

Il est maintenant discuté un exemple de procédé pour la détection d'objets présents dans l'environnement du véhicule utilisant le système de détection selon l'invention. La discussion est faite en référence aux organigrammes des FIGs. 6 et 7.

La FIG. 6 illustre un exemple de procédé de détection d'un objet dans lequel un capteur de lumière reçoit le signal émis. Le procédé est exécuté par le système de détection selon l'invention.

A l'étape S100, une des sources lumineuses électroluminescentes de la matrice de sources lumineuses électroluminescentes émet un signal. Deux ou plus sources lumineuses électroluminescentes peuvent émettent simultanément un signal. Le signal lumineux envoyé peut également être codé de sorte que le ou les capteurs de lumière recevant le signal peuvent identifier quelle source lumineuse a émis le signal.

Ensuite, à l'étape S101, le signal réfléchi par un objet se propage dans un des cônes de réception des capteurs de lumière de la matrice de capteurs de lumière et il est reçu par le capteur de lumière associé à ce cône de réception.

A l'étape S102, l'unité de calcul calcule la position de l'objet qui est déterminée en fonction de la position de l'élément électroluminescent émetteur dans la matrice de sources lumineuses et la position du capteur ayant reçu le signal réfléchi dans la matrice de capteurs de lumière. Ces positions sont transmises à l'unité de calcul par les matrices concernées. La distance de l'objet est calculée par triangulation, comme expliqué en référence à la FIG. 9.

Pour détecter de manière continue les objets de la scène, l'étape S100 est répétée continuellement pour une fréquence donnée, par exemple comprise entre 50 Hz et 200 Hz (Hertz), bornes incluses ; étant entendu que cette plage peut être plus étendue. La fréquence peut de préférence être comprise entre 100Hz et 200 Hz. Lorsqu'il n'y a pas d'objet(s) pouvant être détecté ou que l'objet n'est pas positionné de manière à pouvoir réfléchir le signal en direction des capteurs des matrices de capteurs de lumière, seule l'étape S100 peut être exécutée et répétée. Lorsqu'un signal émis est réfléchi, les étapes S101 et S102 sont alors exécutées.

La FIG. 7 illustre un autre exemple de procédé de détection d'un objet dans lequel au moins deux capteurs reçoivent un signal émis par une source lumineuse.

L'étape S200 est semblable à l'étape S100. Dans l'exemple de la FIG. 7, une source électroluminescente envoie un signal.

A l'étape S201, le signal réfléchi par l'objet est reçu par au moins deux capteurs de la matrice de capteurs de lumière. En pratique, le driver ou bien l'unité de calcul détermine qu'un même signal a été reçu par plusieurs capteurs, par exemple plusieurs signaux marqués à l'aide d'un même code sont reçus durant une période donnée, par exemple durant une période inférieure ou égale à 10ms.

A l'étape S202, il est déterminé quel capteur, parmi les capteurs ayant reçu le même signal réfléchi, a reçu la plus grande intensité lumineuse du signal lumineux. Cette étape de détermination peut être réalisée par le driver ou bien l'unité de calcul.

A l'étape S203, la position de l'objet est calculée comme expliqué à l'étape S102. Cependant, seule la position du capteur recevant la plus grande intensité lumineuse est utilisée pour le calcul de la position de l'objet ; les autres capteurs ayant reçu le même signal ne sont pas pris en compte.

Pour détecter de manière continue les objets de la scène, l'étape S200 est répétée continuellement pour une fréquence qui peut être identique à celle de l'étape S100. Ainsi, les étapes S201 à S203 ne sont exécutées que lorsqu'un signal émis est réfléchi.

La sélection d'une ou plusieurs sources lumineuses électroluminescentes devant émettre les signaux est maintenant discutée.

Dans premier exemple, la sélection est réalisée de manière aléatoire. Par exemple, le driver peut comprendre une fonction pseudo aléatoire permettant de sélectionner une source lumineuse devant être allumée. De la même manière, le driver peut sélectionner aléatoirement deux ou plus sources lumineuses devant être simultanément allumées.

Dans un deuxième exemple, la sélection est réalisée en créant des ensembles de sources lumineuses électroluminescentes. Un ensemble peut par exemple comprendre deux ou plus sources électroluminescentes qui sont voisines, comme par exemple illustré en référence à la FIG. 5. Un ensemble peut comprendre une ou plusieurs lignes de sources lumineuses électroluminescentes d'une matrice, ou bien encore une ou plusieurs colonnes de sources lumineuses électroluminescentes. Les ensembles sont de préférence formés de sorte que chaque source lumineuse d'une matrice appartienne à un seul ensemble.

Lorsqu'un ensemble est sélectionné, les sources lumineuses de cet ensemble vont envoyer un signal. Toutes les sources lumineuses appartenant à un ensemble envoient simultanément un signal. Alternativement, les sources lumineuses d'un ensemble sélectionné envoient successivement un signal.

La sélection d'un ensemble de sources lumineuses électroluminescentes parmi deux ou plus ensembles peut être réalisée de manière aléatoire, ou bien encore selon une séquence prédéterminée. Ainsi, si les ensembles formés comprennent une ou plusieurs lignes de sources lumineuses électroluminescentes, la sélection peut être réalisée de sorte que la prochaine ligne sélectionnée est celle qui est voisine de celle précédemment sélectionnée. De la même manière, si les ensembles formés comprennent une ou plusieurs colonnes de sources lumineuses électroluminescentes, la sélection peut être réalisée de sorte que la prochaine colonne sélectionnée est celle qui est voisine de celle précédemment sélectionnée.

Dans des exemples, la sélection d'un ensemble de sources lumineuses peut dépendre d'une précédente détection d'un signal par un capteur. On sélectionne l'ensemble, parmi les ensembles constitués de sources lumineuses, qui comprend au moins une source électroluminescente qui est adjacente ou voisine - c'est-à-dire qu'il existe au moins un bord ou un sommet en commun - à la source lumineuse électroluminescente ayant émis le signal précédemment détecté. Ainsi, la sélection des sources lumineuses devant envoyer un signal est asservie à une précédente détection. De manière avantageuse, le système de détection peut ainsi affiner la position et la distance d'un objet par rapport au système de détection.

Dans le cas où il n'y a pas d'éléments électroluminescents adjacents à l'élément identifié dans la matrice de sources lumineuses, l'ensemble sélectionné sera celui dont au moins une des sources électroluminescentes d'éléments électroluminescents est la plus proche de la source lumineuse électroluminescente identifiée. Typiquement, une distance euclidienne peut être utilisée pour déterminer la source lumineuse la plus proche.

Les étapes du procédé selon l'invention peuvent être implémentées dans un programme d'ordinateur destiné à la détection d'objet pour véhicule automobile selon l'invention, comportant des instructions de code de programme pour l'exécution des étapes du procédé. Ce programme est alors être exécuté sur une unité de traitement apte à commander le système, selon l'invention, de détection d'objets présenté précédemment. Par exemple, l'unité de traitement peut être l'unité de calcul du système de détection, ou encore un ordinateur de bord d'un véhicule automobile.

Les revendications qui suivent définissent l'objet de la protection conférée pour la présente invention.

## Revendications

1. Système de détection (400) d'objet (405) pour véhicule automobile, comprenant :
- une ou plusieurs matrices (401) de sources lumineuses électroluminescentes (403, 407) ;
- une ou plusieurs matrices (402) de capteurs de lumière (404, 408) ;
- une unité de calcul (413) ;
dans lequel au moins une (403) des sources lumineuses électroluminescentes (403 407) est apte à émettre un signal, au moins un (404) des capteurs (404, 408) est apte à recevoir le signal émis qui a été réfléchi par un objet (405), l'unité de calcul (413) est apte à calculer par triangulation la position de l'objet (405) en fonction de la position dans l'une des matrices (401) de sources lumineuses électroluminescentes (403, 407) de ladite au moins une (403) des sources lumineuses électroluminescentes (403, 407) apte à émettre un signal et de la position dans l'une des matrices (402) de capteurs de lumière dudit au moins un (404) des capteurs (404, 408) apte à recevoir le signal réfléchi par l'objet (405),
**caractérisé en ce que** lesdites une ou plusieurs matrices (401) de sources lumineuses électroluminescentes (403, 407) sont des matrices monolithiques de diodes électroluminescentes et **en ce que** lesdites une ou plusieurs matrices (402) de capteurs de lumière (404, 408) sont des matrices monolithiques de diodes électroluminescentes utilisées comme capteurs de lumière (404, 408).

2. Système selon la revendication 1, dans lequel ladite au moins une (403) des sources lumineuses électroluminescentes (403, 407) est apte à émettre le signal selon une direction (416) contenue dans un cône d'émission, ledit au moins un (404) des capteurs (404, 408) est apte à recevoir le signal réfléchi par l'objet selon une direction (417) contenue dans un cône de réception, et l'unité de calcul (413) est apte à calculer par triangulation la position de l'objet (405) en outre en fonction d'un angle solide (418) du cône d'émission et d'un angle solide (419) du cône de réception.

3. Système selon la revendication 2, dans lequel une intersection du cône d'émission et du cône de réception définit un volume (420) dans lequel se situe l'objet (405) ayant réfléchi le signal émis.

4. Système selon l'une des revendications 1 à 3, dans lequel ladite au moins une (403) des sources lumineuses électroluminescentes (403, 407) est en outre apte à marquer le signal émis par codage du signal émis.

5. Système selon l'une des revendications 2 à 4, dans lequel l'angle solide (418) du cône d'émission est supérieur à l'angle solide (419) du cône de réception.

6. Système selon l'une des revendications 1 à 5, dans lequel au moins une desdites une ou plusieurs matrices (401) de sources lumineuses (403, 407) est comprise dans un premier projecteur pour véhicule automobile.

7. Procédé de détection d'objet pour véhicule automobile qui comprend le système selon l'une des revendications 1 à 6, comprenant les étapes consistant à :
- émettre (S100, S200), par au moins une des sources lumineuses électroluminescentes, un signal ;
- recevoir (S101, S201), par au moins un des capteurs, le signal émis qui a été réfléchi par un objet ;
- calculer (S102, S203), par l'unité de calcul, la position de l'objet en fonction de la position dans l'une des matrices de sources lumineuses de ladite au moins une des sources lumineuses électroluminescentes ayant émis le signal et de la position dans l'une des matrices de capteurs de lumière dudit au moins un des capteurs ayant reçu le signal réfléchi par l'objet.

8. Procédé selon la revendication 7, dans lequel le signal réfléchi par l'objet est reçu par plusieurs capteurs de lumière, et comprenant en outre, après l'étape de recevoir (S201), l'étape consistant à :
- déterminer (S202) le capteur ayant reçu la plus grande intensité du signal parmi lesdits plusieurs capteurs de lumière ayant reçu la lumière réfléchie par l'objet ;
et dans lequel, l'étape de calculer (S203) est réalisée avec la position dans l'une des matrices de capteurs de lumière d'un capteur qui a été identifié comme ayant reçu la plus grande intensité du signal réfléchi par l'objet.

9. Procédé selon la revendication 7 ou 8, comprenant en outre les étapes consistant à :
- former au moins deux ensembles de sources lumineuses électroluminescentes, un ensemble comprenant au moins un parmi :
- les sources lumineuses électroluminescentes d'une ou plusieurs lignes desdites une ou plusieurs matrices de sources lumineuses électroluminescentes ;
- les sources lumineuses électroluminescentes d'une ou plusieurs colonnes desdites une ou plusieurs matrices de sources lumineuses électroluminescentes ;
- au moins une des sources électroluminescentes qui est adjacente à au moins une des sources lumineuses électroluminescentes ayant précédemment émis le signal reçu ;
- sélectionner un des ensembles de sources lumineuses électroluminescentes ; et dans lequel, l'étape d'émettre (S100, S200) est réalisée par la ou les sources lumineuses électroluminescentes de l'ensemble sélectionné.

10. Procédé selon la revendication 9, comprenant en outre, après une première itération du procédé, l'étape consistant à :
- identifier ladite au moins une des sources lumineuses électroluminescentes ayant émis le signal reçu ;
et dans lequel ledit un des ensembles de sources lumineuses électroluminescentes sélectionné comprend au moins une des sources électroluminescentes adjacentes à ladite au moins une des sources lumineuses électroluminescentes identifiée.

11. Procédé selon l'une des revendications 7 à 10, dans lequel une période de répétition des étapes du procédé est inférieure ou égale à 10 ms.

12. Programme d'ordinateur destiné à la détection d'objet pour véhicule automobile par le système selon l'une des revendications 1 à 6, comportant des instructions de code de programme pour l'exécution des étapes du procédé selon l'une quelconque des revendications 7 à 11 lorsque ledit programme est exécuté sur une unité de traitement.

## Patentansprüche

1. Erkennungssystem (400) eines Objekts (405) für ein Kraftfahrzeug, das enthält:
- eine oder mehrere Matrizen (401) von Elektrolumineszenzlichtquellen (403, 407);
- eine oder mehrere Matrizen (402) von Lichtsensoren (404, 408);
- eine Recheneinheit (413);
wobei mindestens eine (403) der Elektrolumineszenzlichtquellen (403, 407) fähig ist, ein Signal zu senden, mindestens einer (404) der Sensoren (404, 408) fähig ist, das gesendete Signal zu empfangen, das von einem Objekt (405) reflektiert wurde, die Recheneinheit (413) fähig ist, durch Triangulation die Position des Objekts (405) abhängig von der Position der mindestens einen (403) der Elektrolumineszenzlichtquellen (403, 407), die fähig ist, ein Signal zu senden, in einer der Matrizen (401) von Elektrolumineszenzlichtquellen (403, 407) und von der Position des mindestens einen (404) der Sensoren (404, 408), der fähig ist, das vom Objekt (405) reflektierte Signal zu empfangen, in einer der Matrizen (402) von Lichtsensoren zu berechnen,
**dadurch gekennzeichnet, dass** die eine oder mehreren Matrizen (401) von Elektrolumineszenzlichtquellen (403, 407) monolithische Matrizen von Elektrolumineszenzdioden sind, und dass die eine oder mehreren Matrizen (402) von Lichtsensoren (404, 408) monolithische Matrizen von Elektrolumineszenzdioden sind, die als Lichtsensoren (404, 408) verwendet werden.

2. System nach Anspruch 1, wobei die mindestens eine (403) der Elektrolumineszenzlichtquellen (403, 407) fähig ist, das Signal gemäß einer in einem Sendekegel enthaltenen Richtung (416) zu senden, der mindestens eine (404) der Sensoren (404, 408) fähig ist, das vom Objekt reflektierte Signal gemäß einer in einem Empfangskegel enthaltenen Richtung (417) zu empfangen, und die Recheneinheit (413) fähig ist, durch Triangulation die Position des Objekts (405) außerdem abhängig von einem Raumwinkel (418) des Sendekegels und einem Raumwinkel (419) des Empfangskegels zu berechnen.

3. System nach Anspruch 2, wobei eine Schnittlinie des Sendekegels und des Empfangskegels ein Volumen (420) definiert, in dem sich das Objekt (405) befindet, das das gesendete Signal reflektiert hat.

4. System nach einem der Ansprüche 1 bis 3, wobei die mindestens eine (403) der Elektrolumineszenzlichtquellen (403, 407) außerdem fähig ist, das gesendete Signal durch Codieren des gesendeten Signals zu markieren.

5. System nach einem der Ansprüche 2 bis 4, wobei der Raumwinkel (418) des Sendekegels größer ist als der Raumwinkel (419) des Empfangskegels.

6. System nach einem der Ansprüche 1 bis 5, wobei mindestens eine der einen oder mehreren Matrizen (401) von Lichtquellen (403, 407) in einem ersten Scheinwerfer für ein Kraftfahrzeug enthalten ist.

7. Verfahren zur Objekterkennung für ein Kraftfahrzeug, das das System nach einem der Ansprüche 1 bis 6 enthält, das die Schritte enthält, die darin bestehen:
- durch mindestens eine der Elektrolumineszenzlichtquellen ein Signal zu senden (S100, S200);
- durch mindestens einen der Sensoren das Signal zu empfangen (S101, S201), das von einem Objekt reflektiert wurde;
- durch die Recheneinheit die Position des Objekts abhängig von der Position der mindestens einen der Elektrolumineszenzlichtquellen, die das Signal gesendet hat, in einer der Matrizen von Lichtquellen und von der Position des mindestens einen der Sensoren, der das vom Objekt reflektierte Signal empfangen hat, in einer der Matrizen von Lichtsensoren zu berechnen (S102, S203).

8. Verfahren nach Anspruch 7, wobei das vom Objekt reflektierte Signal von mehreren Lichtsensoren empfangen wird, und das außerdem nach dem Empfangsschritt (S201) den Schritt enthält, der darin besteht:
- unter den mehreren Lichtsensoren, die das vom Objekt reflektierte Licht empfangen haben, den Sensor zu bestimmen (S202), der die größte Stärke des Signals empfangen hat;
und wobei der Rechenschritt (S203) mit der Position eines Sensors in einer der Matrizen von Lichtsensoren durchgeführt wird, der als derjenige identifiziert wurde, der die größte Stärke des vom Objekt reflektierten Signals empfangen hat.

9. Verfahren nach Anspruch 7 oder 8, das außerdem die Schritte enthält, die darin bestehen:
- mindestens zwei Einheiten von Elektrolumineszenzlichtquellen zu bilden, wobei eine Einheit mindestens eine enthält unter:
- den Elektrolumineszenzlichtquellen einer oder mehrerer Zeilen der einen oder mehreren Matrizen von Elektrolumineszenzlichtquellen;
- den Elektrolumineszenzlichtquellen einer oder mehrerer Spalten der einen oder mehreren Matrizen von Elektrolumineszenzlichtquellen;
- mindestens einer der Elektrolumineszenzquellen, die mindestens einer der Elektrolumineszenzlichtquellen benachbart ist, die vorher das empfangene Signal gesendet hat;
- eine der Einheiten von Elektrolumineszenzlichtquellen auszuwählen;
und wobei der Sendeschritt (S100, S200) von der oder den Elektrolumineszenzlichtquellen der ausgewählten Einheit durchgeführt wird.

10. Verfahren nach Anspruch 9, das außerdem nach einer ersten Iteration des Verfahrens den Schritt enthält, der darin besteht:
- die mindestens eine der Elektrolumineszenzlichtquellen zu identifizieren, die das empfangene Signal gesendet hat;
und wobei die eine ausgewählte der Einheiten von Elektrolumineszenzlichtquellen mindestens eine der Elektrolumineszenzquellen enthält, die der mindestens einen identifizierten der Elektrolumineszenzlichtquellen benachbart sind.

11. Verfahren nach einem der Ansprüche 7 bis 10, wobei eine Wiederholungsperiode der Schritte des Verfahrens kürzer als oder gleich 10 ms ist.

12. Computerprogramm, das zur Objekterkennung für ein Kraftfahrzeug durch das System nach einem der Ansprüche 1 bis 6 bestimmt ist, das Programmcodeanweisungen für die Ausführung der Schritte des Verfahrens nach einem der Ansprüche 7 bis 11 aufweist, wenn das Programm auf einer Verarbeitungseinheit ausgeführt wird.

## Claims

1. Object (405) detection system (400) for a motor vehicle, comprising:
- one or more arrays (401) of electroluminescent light sources (403, 407);
- one or more arrays (402) of light sensors (402, 408);
- a calculating unit (413);
wherein at least one (403) of the electroluminescent light sources (403, 407) is able to emit a signal, at least one (404) of the sensors (404, 408) is able to receive the emitted signal that has been reflected by an object (405), the calculating unit (413) is able to calculate, by triangulation, the position of the object (405) on the basis of the position, in one of the arrays (401) of electroluminescent light sources (403, 407), of said at least one (403) of the electroluminescent light sources (403, 407) able to emit a signal and of the position, in one of the arrays (402) of light sensors, of said at least one of the sensors (404, 408) able to receive the signal reflected by the object (405).
**characterized in that** one or more arrays (401) of electroluminescent light sources (403, 407) are monolithic arrays of monolithic light-emitting diode arrays and **in that** said one or more one or more light sensor (404, 408) arrays (402) are monolithic light-emitting diode arrays light-emitting diode arrays used as light sensors (404, 408).

2. System according to Claim 1, wherein said at least one (403) of the electroluminescent light sources (403, 407) is able to emit the signal in a direction (416) contained in an emission cone, said at least one (404) of the sensors (404, 408) is able to receive the signal reflected by the object in a direction (417) contained in a reception cone, and the calculating unit (413) is able to calculate, by triangulation, the position of the object (405) furthermore on the basis of a solid angle (418) of the emission cone and of a solid angle (419) of the reception cone.

3. System according to Claim 2, wherein an intersection of the emission cone and of the reception cone defines a volume (420) in which the object (405) that reflected the emitted signal is situated.

4. System according to one of Claims 1 to 3, wherein said at least one (403) of the electroluminescent light sources (403, 407) is furthermore able to mark the emitted signal through coding of the emitted signal.

5. System according to one of Claims 2 to 4, wherein the solid angle (418) of the emission cone is greater than the solid angle (419) of the reception cone.

6. System according to one of Claims 1 to 5, wherein at least one of said one or more arrays (401) of light sources (403, 407) is contained in a first motor vehicle headlight.

7. Object detection method for a motor vehicle that comprises the system according to one of Claims 1 to 6, comprising the steps of:
- emitting (S100, S200), by way of at least one of the electroluminescent light sources, a signal;
- receiving (S101, S201), by way of at least one of the sensors, the emitted signal that has been reflected by an object;
- calculating (S102, S103), by way of the calculating unit, the position of the object on the basis of the position, in one of the arrays of light sources, of said at least one of the electroluminescent light sources that emitted the signal and of the position, in one of the arrays of light sensors, of said at least one of the sensors that received the signal reflected by the object.

8. Method according to Claim 7, wherein the signal reflected by the object is received by a plurality of light sensors, and furthermore comprising, after the reception step (S201), the step consisting of:
- determining (S202) the sensor that received the greatest intensity of the signal from among said plurality of light sensors that received the light reflected by the object;
- and wherein the calculating step (S203) is performed with the position, in one of the arrays of light sensors, of a sensor that has been identified as having received the greatest intensity of the signal reflected by the object.

9. Method according to Claim 7 or 8, furthermore comprising the steps of:
- forming at least two sets of electroluminescent light sources, a set comprising at least one from among:
- the electroluminescent light sources of one or more rows of said one or more arrays of electroluminescent light sources;
- the electroluminescent light sources of one or more columns of said one or more arrays of electroluminescent light sources;
- at least one of the electroluminescent sources that is adjacent to at least one of the electroluminescent light sources that previously emitted the received signal;
- selecting one of the sets of electroluminescent light sources;
and wherein the emission step (S100, S200) is performed by the electroluminescent light source(s) of the selected set.

10. Method according to Claim 9, furthermore comprising, after a first iteration of the method, the step of:
- identifying said at least one of the electroluminescent light sources that emitted the received signal;
and wherein said one of the selected sets of electroluminescent light sources comprises at least one of the electroluminescent sources adjacent to said at least one of the identified electroluminescent light sources.

11. Method according to one of Claims 7 to 10, wherein a period of repetition of the steps of the method is less than or equal to 10 ms.

12. Computer program for object detection for motor vehicles using the system according to one of claims 1 to 6, including program code instructions for executing the steps of the method according to any one of Claims 7 to 11 when said program is executed on a processing unit.
